# EUROPEAN PATENT SPECIFICATION

(11) **EP 0 542 156 B1**
(45) Date of publication and mention of the grant of the patent: **12.08.1998**
(21) Application number: 92119067.4
(22) Date of filing: 06.11.1992
(51) Int. Cl.: G11C 16/06

(54) **Method of updating data stored in storage locations of a flash EPROM**
Verfahren zur Aktualisierung von Daten in Speicherplätzen eines Flash-EPROM-Speichers
Méthode de mise à jour de données emmagasinées dans des locations d'emmagasinage d'un EPROM-Flash

(30) Priority: 15.11.1991 IT MI913066
(43) Date of publication of application: 19.05.1993
(73) Proprietor: ALCATEL ALSTHOM COMPAGNIE GENERALE D'ELECTRICITE, 75008 Paris (FR)
(72) Inventor: Lisca, Lorenzo, Milano (IT); Barillari, Maurizio, Milano (IT)
(74) Representative: Pohl, Herbert, Dipl.-Ing.

(56) References cited:
- EP-A- 357 464
- GB-A- 2 227 584
- JP-A-59 071 179
- PATENT ABSTRACTS OF JAPAN vol. 8, no. 179 (P-295)(1616) 17 August 1984 & JP-A-59 71 180
- IBM TECHNICAL DISCLOSURE BULLETIN. vol. 12, no. 9, February 1970, NEW YORK US, pages 1441-1442, SMITH ET AL.: "Substitute memory location assignment for faulty locations"
- PATENT ABSTRACTS OF JAPAN vol. 7, no. 82 (P-189)(1227) 6 April 1983 & JP-A-58 9 291

## Description

The present invention relates to a method of updating data stored in storage locations of a storage unit, in particular of a Flash EPROM.

Updating of data stored in some types of storage units, particularly non-volatile memories, is a problem because it is a time consuming activity and often quasi-independent from the amount of updating to be carried out, too.

This is the case e.g. of disks for which access time is mainly due to mechanical movements of heads. Each disk reader includes a logic circuit for controlling the disk write physical operations. Normally as soon as a writing or updating command is received, a write physical operation occurs. This method normally involves an enormous waste of time due to the fact that consecutive write logic operations correspond to consecutive write physical operations on different and often distant physical areas of the disk, and therefore a long time is consumed for moving heads from one disk area to another.

The same problem arises with Flash EPROMs. Flash EPROMs are a special type of EEPROMs whose cost is remarkably lower than conventional EEPROMs and moreover the attainable integration degree on a chip is higher (256 kbytes per chip against 32 kbytes per chip).

The main difference between the two types of device lies in that Flash EPROMs must be erased totally (like UV EPROMs), i.e. erasure concerns the entire chip, by a simple electrical command, whilst EPROMs are erased on a byte by byte basis; both types of memories are written on a byte by byte basis.

An important feature of Flash EPROMs lies in that it is possible to change the value of any bit from 1 to 0 (programming operating) but it is necessary to erase the entire memory device (erase operation) in order to change the value of a bit from 0 to 1. The erase operation goes on for some seconds and consists in turning to 1 all bits of the memory device; Flash EPROM manufactures, e.g. Advanced Micro Devices, recommend to turn, via software or firmware, all the bits of the memory device to 0 before executing such erasing operation in such a way that the locations of the memory device are "consumed" uniformly.

Therefore, when it is necessary to change even a single bit from 0 to 1, first the content of the entire Flash EPROM has to be transferred to a RAM having at least the same capacity, then the value of the bit is to be changed, after which the erasing action is carried out and finally the content of the RAM is to be copied again in the Flash EPROM. It is clear that such a method is time consuming and this is particularly disadvantageous especially when the content of the memory device has to be changed frequently.

Should one often change the content of single or few bytes, the use of such method requires not to exceed the maximun limit of erasure/write cycles (1000 to 10000) warranted as to be error-free for such type of device, which is a further problem.

The German Patent Application DE 3741278 discloses an arrangement such as to assure an error-free operation for an EEPROM subjected to a number of erasure/write cycles greater than those allowed for individual locations of EEPROM itself.

The invention as disclosed in the above-mentioned German Patent Application, is based upon a store having a capacity greater than the number of memory zones (comprising several bytes) each time necessary for data to be stored at the same time, and consists first of all in storing data in a single memory zone and then in switching, according to a suitable criterion, on a successive memory zone under the control of a memory controller, and use this successive memory zone until such suitable criterion suggests otherwise; hence it is substantially a question of operative environment change.

The method, as disclosed in the above-mentioned patent application, requires memories of much higher capacity than really needed and moreover it does not solve the problem of quick updating the stored data.

The japanese patent abstract JPA59071159 discloses a method to correct the information content of an EEPROM memory by reading all the information to a RAM on an IC card processor and by editing in real time the data to be corrected before rewriting the information content on the EEPROM.

This method does not allow for any time saving or writing EEPROM cycle saving, since the rewrite cycles are equal to the information updating operations, thus leading to a decrease of EEPROM lifetime and longer overall process time.

In the european patent application EPA 0357464, the data to be written are stored into a RAM cache memory and a working disk. This method and apparatus aims to increase the effective lifetime of the data optical disks and to backup data in case data optical disk failure. It is described thet the cache memory is a continuosly operating storage means, with the data replica on the working disk.

The IBM Technical Disclosure Bulletin (Smith G. H. et al., "Substitute memory location assignment for faulty locations," vol. 12, (1970), p. 1441) describes a method to assign substitute locations when solid memory failures are disclosed.

With the method mentioned, there is a simple data replica on the storage location without, again, any time saving or writing cycle saving, looking only to the preservation of the availability of stored data.

It is an object of the present invention to overcome the drawbacks of prior art methods.

This object is achieved by a method of updating data stored in storage locations of a storage unit, in particular of a flash EPROM having the characteristics set forth in claim 1. Further advantageous aspects of the invention are set forth in the subclaims.

A remarkable reduction in updating time can be attained by writing information relative to updating to be carried out into not occupied storage locatins and executing the updating all at once on the storage locations containing data.

The invention will now be described with reference to the attached drawings in which:
Fig. 1 - shows the structure of a storage unit and a possible storage allocation for updating information according to the present invention,
Fig. 2 - shows the structure of a storage unit and another possible storage allocation for updating information according to the present invention,
Figs. 3 to 7 - show a possible evolution in time of the content of storage locations containing data and updating information, according to the present invention, and
Figs. 8 to 11 - show another possible evolution in time of the content of storage locations containing data and updating information, according to the present invention.

In the following, reference will be always made to the case in which the method according to this invention is applied to Flash EPROMs, but the same applies to e.g. disks.

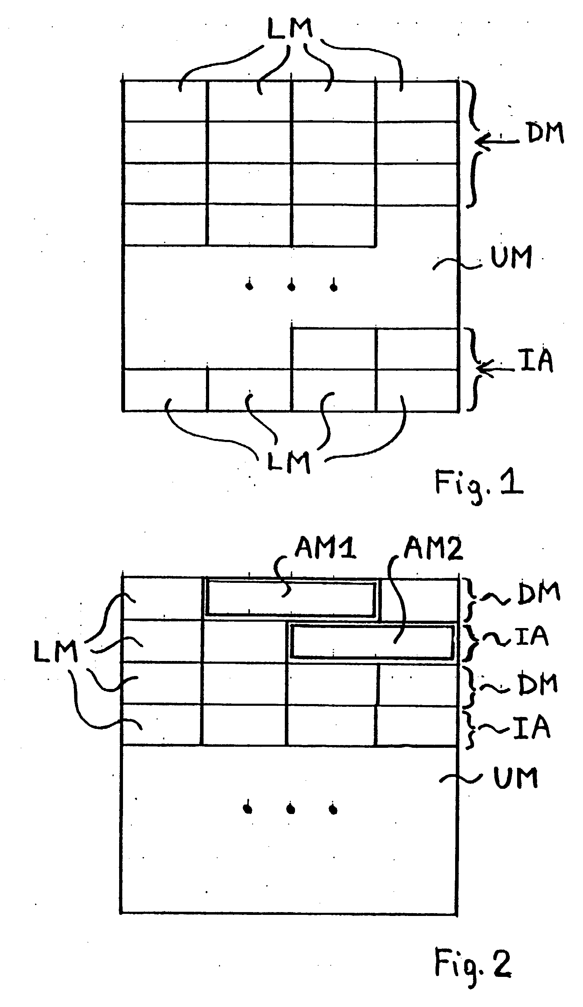

With reference to figs 1 and 2, UM stands for a generic storage unit. Such storage unit UM is organized in storage locations LM. Data are normally written into the memory starting either from the smallest address, as illustrated in figs. 1 and 2, or from the greatest one, and constitute the stored data DM. Consecutive storage locations LM are often used, but in general the control of memory allocation is entrusted to software or firmware.

Stored data DM are updated, either by software of firmware, by sending write commands, more properly "overwrite" ones, consisting of the data address to be updated and the new binary value of the data itself, to the storage unit UM.

As said, to make storage unit UM execute write commands as they are received,can be not very efficient, as in case of disks, or it may result not possible, as in the case of Flash EPROMs where an "overwrite" generally involves a total erasure of the device.

A high gain in efficiency is obtained by loading updating information IA into not occupied, i.e. virgin, storage locations LM. Such updating information IA generally consists in a number of updatings, stored data DM, accumulated in course of time.

The loaded updating information IA can be read out, either occasionally or periodically, and used for updating effectively the stored data DM which such updating information IA is referred to.

Naturally, once updating information IA has been applied to stored data DM, the storage locations LM used to contain it can be reset for future use.

These three operations i.e. loading, updating and reset can be repeated.

In fig.1 there is illustrated the case wherein updating information IA is loaded into storage locations LM distinct from storage location LM used for stored data DM.

In fig. 2, on the contrary, updating information IA and stored data DM alternate in the storage locations LM.

Besides the choice of the physical dislocation of updating information IA it is necessary to make always a choice of the logical dislocation of such information.

A first possibility, illustrated in fig.1, is to write consecutively all updating information in a well defined storage area independently from the fact that they refer to well defined storage locations. In this instance the updating information shall contain at least a first sequence of bits containing the address of the storage location to be updated, and a second sequence of bits containing the new binary value of the storage location to be updated.

When it is desired to update several consecutive storage locations, a third sequence of bits, containing the number of storage locations in which the content is to be updated, in also needed; the first sequence of bits correspond now to starting address of consecutive storage locations and the second sequence of bits will be the new global binary value.

Updating information IA generally will include a plurality of such sequences of bits.

A second possibility, illustrated in fig. 2, is to dedicate to a first storage area AM1 a second storage area AM2 capable of containing updating information IA relative to the first storage area AM1. Naturally several pairs of such storage areas may be contemplated. In this case the updating information shall contain only a sequence of bits corresponding to the new binary value of the first storage area AM1.

Whatever the physical and logical arrangement of updating information IA is, the advantage in time lies in that loading of updating information IA into not occupied storage locations is not time consuming operation and the total erasure of the device occurs only when a number, pre-establisched by software or firmware, of updatings have to be executed, or at regular intervals, contrary to what was contemplated in the methods used up to now wherein an erasure for each updating was carried out.

In order to better understand the behaviour of the method according to the present invention two examples of possible evolution in time of the content of storage during an updating phase will be now illustrated. In the following the content of storage locations will be expressed as an esadecimal number.

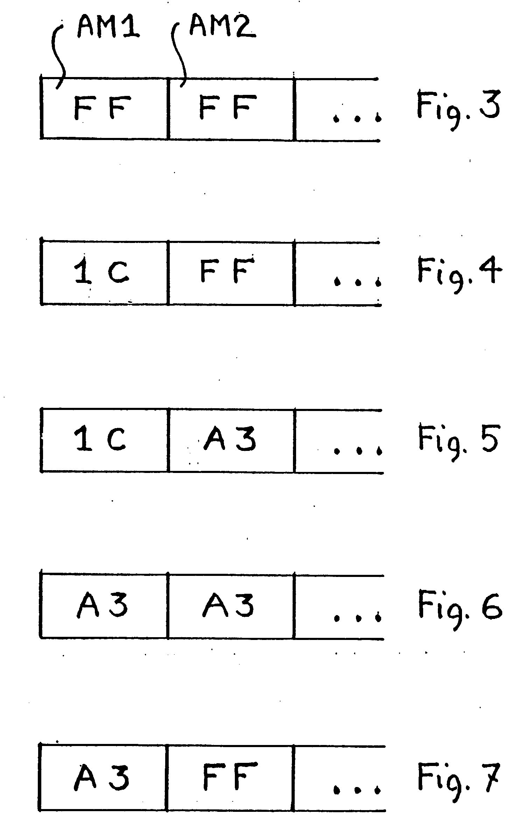

The first example refers to figs. 3 to 7. The first storage location is indicated by AM1 and corresponds to the first storage area to be updated. The second storage location is indicated by AM2 and corresponds to the second storage area which has to contain the new binary value. At first both storage locations are virgin and their binary value is FF (see fig. 3), as happens in Flash EPROM memories. As a result of a software evolution the first storage location stores the binary value 1C (see fig. 4). The evolution of the software involves then the need of updating the binary value of the first storage location to A3. The method according to the present invention teaches that such new binary value shall not overwrite the old one but it must be loaded into the second storage location, see fig.5. At a very moment, at discretion of software or firmware, data 1C stored will be updated with the new one A3 (see fig. 6) and then the second storage location will he reset to its initial binary value FF, see fig. 7.

In the special case of Flash EPROMs, when software or firmware decides at a well precise moment to apply updatings, it copies the content of the entire flash EPROM memory into an RAM memory, usually identical to the first one; therefore fig. 5 represents at the same time the content of two storage locations of Flash EPROM and RAM. The content A3 of the second storage location, of RAM, is copied into the first storage location of RAM, as illustrated in fig.6. Subsequently, the content of the second storage location of RAM, is reset to FF, as shown in fig. 7.

At this point the Flash EPROM is erased completely and then is programmed by using the content of the RAM memory. After such operation, the contents of Flash EPROM and RAM will be identical; therefore fig. 7 represents at the same time the content of two storage locations of Flash EPROM and of RAM.

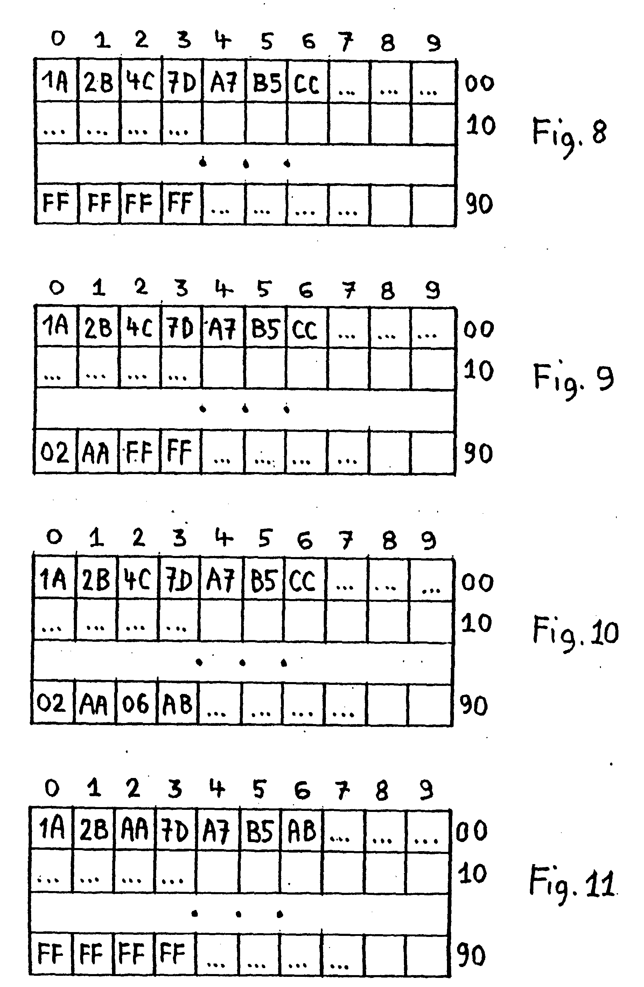

The second example refers to figs 8 to 11. The storage unit has one hundred storage locations, each of a byte, arranged as a matrix having ten columns numbered 0, 1, 2,...., 9, and ten rows numbered 00, 10, 20,..., 90. Stored in the first nine rows are data DM and the updating information IA is loaded in the last row. The address LC of a storage location is obtained by summing numbers corresponding to the row and column of the location itself.

At first, as illustrated in fig. 8, the content of storage locations having address from 00 to 06 is respectively : 1A, 2B, 4C, 7D, A7, B5, CC and these correspond to stored data. In the storage locations dedicated to updating information there is still no data. The evolution of a software involves afterwards the need of updating the binary value of the storage location whose address is 02 to the new binary value AA. The method according to the present invention teaches that such new binary value shall not overwrite the old one.In the storage locations having address 90 and 91 updating information corresponding to address 02 and to the new binary value AA are then loaded respectively, as shown in fig. 9. Afterwards there is a new need of updating the binary value of the storage location whose address is 06 to the new binary value AB. Such updating information is then loaded into storage locations whose addressess are 92 and 93, as shown in fig. 10. As already seen in the foregoing example, at a well precise moment, at software or firmware's discretion, the updating information is applied to the stored data. Software or firmware scans the list of the loaded updatings starting from storage location 90 and consequently updates the storage locations containing stored data; finally, storage locations 90, 91, 92 and 93 are reset to FF, as shown in fig. 11.

As in the preceding example, in the special case of Flash EPROMs, the updating physical operation has to occur on the RAM memory and this involves two copy operations (from Flash EPROM to RAM and from RAM to Flash EPROM) and an operation of total erasure of the Flash EPROM.

When a sofware requests the read out of a data stored in a storage unit UM, it sends a read out command basically consisting in the address of data to be read. In case the method according to the present invention is used for stored data updating operations, it may happen that the content of the storage location corresponding to the data to be read is not yet updated. In order to obtain a correct readout it is resposibility of software, or rather of the firmware, to check if there is any updating information loaded into memory.

Taking up the two foregoing examples again, in the first instance it will be sufficient to ckeck whether the content of the second storage area is FF, whilst in the second instance it will be necessary to scan the storage locations corresponding to the last row and, more precisely, it will be necessary to check if one or more of locations having even address 90, 92, 94, 96, 98 contain a binary value corresponding to the address of the data to be read and, consequently, to provide software with the most recent binary value.

The method according to the present invention may be used with the subscriber data memories of exchanges and "intelligent" telephone concentrators i.e. with local switching capacities, and in general with data storages of computers used for controlling industrial processes.

In such applications data storages, or at least a part thereof, are of type non-volatile, advantageously of type Flash EPROM for cost and occupied room reasons, so that a lack of feed do not cause a loss of data. In such data storages, directories are often stored, used as an access index for other data stored in the data storage themselves and composed of a set of equal records, one for each element od the index.

The importance of such directories is of course very high and it is common practice to contemplate a field in every record, capable of containing information that allow to verify if a corruption in the memory occurred : such field is called check-sum. The binary value of the check-sum depends upon the binary value of data contained in the record itself. As new data are added in the record, the check sum is to be updated in such a way that an error is not raised during the corruption verification phase. In order to avoid useless and long erasures and rewrites of the memory devices it is of advantage to use the method according to the present invention at every adding of data contemplating, in addition to the first check-sum field, a number of further check-sum fields, e.g. one or two for each record, so that further updatings are loaded on successive check-sum fields and that such fields are then periodically reset after the physical updating of the first one.

## Claims

1. Method of updating data (DM) stored in first locations (LM) of a Flash EPROM (UM) comprising the steps of:
providing updating information (IA) containing data values to be written at storage locations which are to be updated,
characterised by:
loading the updating information into non-occupied second storage locations (LM) of said Flash EPROM,
checking, when readout of data stored in said Flash EPROM is requested, whether updating information (IA) exists for the requested data,
providing the most recent data value for read out.

2. Method according to claim 1, characterized in that updating information (IA) stored in non occupied storage location is read out independently from the actual updating of stored data (DM) at said storage locations to be updated and in that the correct read out is responsibility of software or firmware

3. Method according to claim 1, characterized in that storage locations containing said stored data (DM) are updated by using said loaded updating information (IA)

4. Method according to claim 3 characterized in that once storage locations containing said stored data are updated, the storage locations containing said updating information are reset

5. Method according to claim 4 characterized in that said loading, said updating and said resetting are repeated

6. Method according to claim 1, characterized in that the updating information relative to a first specific storage area are loaded into a second specific storage area

7. Method according to claim 1, characterized in that said updating information comprises at least a first sequence of bits corresponding to the new binary value of specific stored data

8. Method according to claim 7, characterized in that said updating information further comprises at least a second sequence of bits corresponding to the address of said specific stored data

9. Method according to claim 8, characterized in that said updating information further comprises at least a third sequence of bits corresponding to the number of storage locations occupied by said specific stored data

10. Method according to claim 1, characterized in that said non occupied storage locations belong to the same storage unit.

## Patentansprüche

1. Verfahren zum Aktualisieren von auf ersten Speicherplätzen (LM) eines Flash-EPROMs (UM) gespeicherten Daten (LM), die folgenden Schritte umfassend:
Bereitstellen von Aktualisierungsinformationen (IA), die Datenwerte enthalten, um diese auf Speicherplätze zu schreiben, die aktualisiert werden sollen,
gekennzeichnet durch:
Laden der Aktualisierungsinformationen auf nicht belegte, zweite Speicherplätze (LM) des Flash-EPROMs,
Überprüfen, wenn ein Auslesen von in dem Flash-EPROM gespeicherten Daten angefordert wird, ob für die angeforderten Daten Aktualisierungsinformationen (IA) vorhanden sind,
Bereitstellen der neuesten Datenwerte für das Auslesen.

2. Verfahren gemäß Anspruch 1, dadurch gekennzeichnet, daß die auf den nicht belegten Speicherplätzen gespeicherten Aktualisierungsinformationen (IA) unabhängig von dem momentanen Aktualisieren gespeicherter Daten (DM) auf den zu aktualisierenden Speicherplätzen ausgelesen werden, und dadurch, daß für das korrekte Auslesen die Software oder Firmenware verantwortlich ist.

3. Verfahren gemäß Anspruch 1, dadurch gekennzeichnet, daß Speicherplätze, die die gespeicherten Daten (DM) enthalten, durch Verwenden der geladenen Aktualisierungsinformationen (IA) aktualisiert werden.

4. Verfahren gemäß Anspruch 3, dadurch gekennzeichnet, daß, wenn die Speicherplätze, die die gespeicherten Daten enthalten, aktualisiert sind, die Speicherplätze zurückgesetzt werden, die die Aktualisierungsinformationen enthalten.

5. Verfahren gemäß Anspruch 4, dadurch gekennzeichnet, daß das Laden, das Aktualisieren und das zurücksetzen wiederholt werden.

6. Verfahren gemäß Anspruch 1, dadurch gekennzeichnet, daß die sich auf einen speziellen Speicherbereich beziehenden Aktualidierungsinformationen in einen zweiten speziellen Speicherbereich geladen werden.

7. Verfahren gemäß Anspruch 1, dadurch gekennzeichnet, daß die Aktualisierungsinformationen mindestens eine erste .Bitfolge umfassen, die dem neuen binären Wert spezieller gespeicherter Daten entspricht.

8. Verfahren gemäß Anspruch 7, dadurch gekennzeichnet, daß die Aktualisierungsinformationen desweiteren mindestens eine zweite Bitfolge umfassen, die der Adresse der speziellen gespeicherten Daten entspricht.

9. Verfahren gemäß Anspruch 8, dadurch gekennzeichnet, daß die Aktualisierungsinformationen desweiteren mindestens eine dritte Bitfolge umfassen, die der Anzahl der von den speziellen gespeicherten Daten belegten Speicherplätze entspricht.

10. Verfahren gemäß Anspruch 1, dadurch gekennzeichnet, daß die nicht belegten Speicherplätze zu derselben Speichereinheit gehören.

## Revendications

1. Procédé de mise à jour de données (DM) stockées dans des premiers emplacements (LM) d'une mémoire morte programmable électriquement (EPROM) Flash (UM) comprenant les étapes consistant à :
- fournir une information de mise à jour (IA) contenant les valeurs des données devant être écrites aux emplacements de stockage qui doivent être mis à jour.
caractérisé par les étapes consistant à :
- charger l'information de mise à jour dans des seconds emplacements de stockage non occupés (LM) de ladite mémoire EPROM-Flash,
- vérifier, lorsque la lecture des données stockées dans ladite mémoire EPROM-Flash est requise, si l'information de mise à jour (IA) existe pour les données requises,
- fournir la valeur la plus récente des données à des fins de lecture.

2. Procédé selon la revendication 1, caractérisé en ce que l'information de mise à jour (IA) stockée dans les emplacements de stockage non occupés est lue indépendamment de la mise à jour réelle des données stockées (DM) auxdits emplacements de stockage devant être mis à jour et en ce que la lecture correcte est la responsabilité du matériel ou du logiciel.

3. Procédé selon la revendication 1, caractérisé en ce que les emplacements de stockage contenant lesdites données stockées (DM) sont mis à jour en utilisant ladite information de mise à jour chargée (IA).

4. Procédé selon la revendication 3, caractérisé en ce que dès que les emplacements de stockage contenant lesdites données stockées sont mis à jour, les emplacements de stockage contenant ladite information de mise à jour sont remis à l'état initial.

5. Procédé selon la revendication 4, caractérisé en ce que ledit chargement, ladite mise à jour et ladite remise à l'état initial sont répétés.

6. Procédé selon la revendication 1, caractérisé en ce que les informations de mise à jour relatives à une première zone de stockage spécifique sont chargées dans une seconde zone de stockage spécifique.

7. Procédé selon la revendication 1, caractérisé en ce que ladite information de mise à jour comprend au moins une première séquence de bits correspondant à la nouvelle valeur binaire des données spécifiques stockées.

8. Procédé selon la revendication 7, caractérisé en ce que ladite information de mise à jour comprend au moins une seconde séquence de bits correspondant à l'adresse desdites données spécifiques stockées.

9. Procédé selon la revendication 8, caractérisé en ce que ladite information de mise à jour comprend en outre au moins une troisième séquence de bits correspondant au nombre des adresses de stockage occupées par lesdites données spécifiques stockées.

10. Procédé selon la revendication 1, caractérisé en ce que lesdits emplacements de stockage non occupés appartiennent à la même unité de stockage.
